(19) Europäisches Patentamt
European Patent Office
Office européen des brevets

(11) EP 2 126 997 B1

(12) **EUROPÄISCHE PATENTSCHRIFT**

(45) Veröffentlichungstag und Bekanntmachung des Hinweises auf die Patenterteilung:
**19.12.2012 Patentblatt 2012/51**

(21) Anmeldenummer: **08715846.5**

(22) Anmeldetag: **19.02.2008**

(51) Int Cl.:
***H01L 51/42*** *(2006.01)*

(86) Internationale Anmeldenummer:
**PCT/EP2008/001252**

(87) Internationale Veröffentlichungsnummer:
**WO 2008/104301 (04.09.2008 Gazette 2008/36)**

(54) **HYBRIDE ORGANISCHE SOLARZELLEN MIT VON PHOTOAKTIVEN OBERFLÄCHENMODIFIKATOREN UMGEBENEN HALBLEITER- NANOPARTIKELN**

HYBRID ORGANIC SOLAR CELLS WITH PHOTOACTIVE SEMICONDUCTOR NANOPARTICLES ENCLOSED IN SURFACE MODIFIERS

CELLULES SOLAIRES ORGANIQUES HYBRIDES COMPRENANT DES NANOPARTICULES DE SEMI-CONDUCTEUR ENROBÉES DE MODIFICATEURS DE SURFACE PHOTOACTIFS

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **27.02.2007 DE 102007009790**

(43) Veröffentlichungstag der Anmeldung:
**02.12.2009 Patentblatt 2009/49**

(73) Patentinhaber: **Bayer Intellectual Property GmbH
40789 Monheim (DE)**

(72) Erfinder:
- **RAUSCHER, Frank
50968 Köln (DE)**
- **HOHEISEL, Werner
51061 Köln (DE)**
- **HENNINGER, Björn
50677 Köln (DE)**
- **MLECZKO, Leslaw
41542 Dormagen (DE)**

(74) Vertreter: **Bayer Intellectual Property GmbH
Creative Campus Monheim
Alfred-Nobel-Straße 10
40789 Monheim (DE)**

(56) Entgegenhaltungen:
**EP-A- 1 473 745 WO-A-2004/022714
WO-A-2005/107047 US-A1- 2006 216 610**

- **SCHMIDT-MENDE LUKAS ET AL: "Efficiency improvement in solid-state-dye-sensitized photovoltaics with an amphiphilic Ruthenium-dye" APPLIED PHYSICS LETTERS, AIP, AMERICAN INSTITUTE OF PHYSICS, MELVILLE, NY, Bd. 86, Nr. 1, 28. Dezember 2004 (2004-12-28), Seiten 13504-013504, XP012064478 ISSN: 0003-6951**
- **WANG ET AL: "In situ polymerization of amphiphilic diacetylene for hole transport in solid state dye-sensitized solar cells" ORGANIC ELECTRONICS, ELSEVIER, AMSTERDAM, NL, Bd. 7, Nr. 6, 18. November 2006 (2006-11-18), Seiten 546-550, XP005773063 ISSN: 1566-1199**
- **WANG P ET AL: "AMPHIPHILIC POLYPYRIDYL RUTHENIUM COMPLEXES WITH SUBSTITUTED 2,2'-DIPYRIDYLAMINE LIGANDS FOR NANOCRYSTALLINE DYE-SENSITIZED SOLAR CELLS" CHEMISTRY OF MATERIALS, AMERICAN CHEMICAL SOCIETY, WASHINGTON, US, Bd. 16, Nr. 17, 24. August 2004 (2004-08-24), Seiten 3246-3251, XP008068064 ISSN: 0897-4756**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 126 997 B1

Printed by Jouve, 75001 PARIS (FR)

## Beschreibung

Die vorliegende Erfindung bezieht sich auf das Gebiet der Solarzellen, insbesondere der hybriden organischen Solarzellen.

Derartige Solarzellen sind unter anderem aus der US 6,878,871 bekannt. In diesem Dokument wird eine Solarzelle beschrieben, bei der Halbleiter-Nanopartikel in der photoaktiven Schicht angeordnet sind.

In der EP 1 473 745 A werden farbbeschichtete Solarzellen beschrieben, in denen die Farbe ein amphiphiler Ruthenium-Polypyridil Komplex ist und auf denen zusätzlich ein Stabilisierungsmittel coadsorbiert ist, dessen molekulare Struktur einen hydrophoben Anteil und eine Ankergruppe aufweist. Die Farbbeschichtung und das coadsorbierte Stabilisierungsmittel sind auf der halbleitenden Metaloxidschicht der Photoanode aufgebracht.

L. Schmidt-Mende et al. beschreiben in "Efficiency improvement in solid-state-dye-sensitized photovoltaics with an amphiphilc Ruthenium-dye" erschienen in Appl. Phys. Lett. 86 (2004) ebenfalls Farbbeschichtungen, wobei die Farben amphiphile Eigenschaften aufweisen.

In der WO 2004/022714 A werden weitere Zusammensetzungen beschrieben, die den Ladungstransport über eine nanokristalline Oberfläche oder durch eine Nanokristalle enthaltende Matrix zu verändern vermögen. Solche Zusammensetzung sind gemäß der WO 2004/022714 A verwendbar in Solarzellen.

Diese sowie ähnliche Solarzellen aus dem Stand der Technik haben jedoch häufig nur eine unbefriedigende Leistungseffizienz. Dies wird unter anderem darauf zurückgeführt, dass es sich als problematisch herausgestellt hat, die durch Absorption von Photonen erzeugten Exzitonen (gebundenes Elektronen-Loch Paar) durch effizienten Ladungstransfer an der Grenzfläche Nanopartikel/Polymer schnell zu trennen, um eine leistungsmindernde Rekombination innerhalb der Solarzelle zu verhindern.

Es stellt sich somit die Aufgabe, eine hybride organische Solarzelle zu schaffen, welche eine höhere Leistungseffizienz bei zumindest nicht wesentlich verschlechterten, bevorzugt sogar gleichbleibenden oder verbesserten sonstigen Eigenschaften aufweist.

Zur Lösung dieser Aufgabe wird eine Solarzelle gemäß Anspruch 1 der vorliegenden Erfindung bereitgestellt.

Dadurch, dass die Halbleiter-Nanopartikel mindestens von einem Tensidmaterial gemäß dem Anspruch 1 umgeben sind, konnte innerhalb eines weiten Bereichs von Anwendungen der vorliegenden Erfindung eine deutlich erhöhte Effizienzsteigerung festgestellt werden, was - ohne auf eine solche Theorie beschränkt zu sein - auf die verbesserte Ladungstrennung an der Grenzfläche zwischen Nanopartikel und halbleitender organischer Matrix, z. B. ein halbleitendes Polymer, innerhalb der photoaktiven Schicht der Solarzelle zurückgeführt wird. Unter "photoaktiv" im Sinne der vorliegenden Erfindung wird insbesondere verstanden, dass Licht durch Generierung von Exzitonen absorbiert wird.

Unter "Tensidmaterial" im Sinne der vorliegenden Erfindung wird insbesondere ein Material verstanden, welches im Wesentlichen aus Molekülen besteht, die eine polare Kopfgruppe (wie z.B. - aber nicht darauf beschränkt - eine Carboxyl-, Amin-, Thiol-, Phosphat- oder Sulfatgruppe) und eine unpolare Schwanzgruppe beinhalten.

Unter "photoaktivem Tensidmaterial" im Sinne der vorliegenden Erfindung wird insbesondere verstanden, dass das mindestens eine Tensidmaterial ein höchstes besetztes Molekülorbital (HOMO) sowie ein niedrigstes unbesetztes Molekülorbital (LUMO) besitzt, dessen energetische Lage derart ist, dass eine Trennung der durch Lichtabsorption erzeugten Ladungsträger in das Halbleiter-Nanopartikel und/oder in die umgebende organische Matrix möglich ist (entsprechend dem in der Halbleiter-Technologie so genannten Typ II Übergang). Zusätzlich wurde bei vielen Anwendungen innerhalb der vorliegenden Erfindung aufgrund der Eigenschaften des Tensides hinsichtlich Loch- und/oder Elektronleitfähigkeit die Ladungstrennung der Exzitonen, welche innerhalb der Nanopartikel und/oder der umgebenden organischen Matrix, z.B. ein halbleitendes Polymer, durch Lichtabsorption entstehen, verbessert.

An der Grenzfläche eines Typ II Übergangs wird das Material mit dem energetisch niedrigeren LUMO auch Akzeptor und das Material mit dem energetisch höheren HOMO Donor genannt.

Unter "Halbleiter-Nanopartikel" im Sinne der vorliegenden Erfindung werden anorganische Materialien, welche im wesentlichen kristallin oder angenähert kristallin ausgebildet sind, eine Bandlücke von $\geq 0{,}5$ bis $\leq 3{,}5$ eV besitzen und im Durchschnitt eine charakteristische Größenausdehnung im Bereich von $\geq 1$ nm bis $\leq 50$ nm, bevorzugt $\geq 1{,}5$ nm bis $\leq 40$ nm, besonders bevorzugt $\geq 2$ nm bis $\leq 30$ nm aufweisen. Unter charakteristische Größenausdehnung im Sinne der vorliegenden Erfindung wird die Abmessung der Nanoteilchen verstanden, die für deren physikalisch-chemischen Eigenschaften bestimmend ist. Dies ist bei spherischen Teilchen der Durchmesser, bei länglichen Teilchen, z.B. Stäbchen, der Stäbchendurchmesser und bei mehrarmigen Teilchen der Armdurchmesser.

Die erfindungsgemäßen Halbleiter-Nanopartikel gemäß Anspruch 1 aus der Gruppe der II-VI oder III-V-Verbindungshalbleiter (z.B. CdSe, CdTe, InP) und Mischungen daraus haben die vorgenannten Eigenschaften.

Gemäß einer bevorzugten Ausführungsform der vorliegenden Erfindung enthält das mindestens eine photoaktive Tensidmaterial ein p- und n-leitendes Material.

Gemäß einer bevorzugten Ausführungsform der vorliegenden Erfindung beträgt die Belegungsdichte der Halbleiter-Nanopartikeloberfläche mit mindestens einem photoaktiven Tensidmaterial $\geq 50\%$ bis $\leq 100$ %, besonders bevorzugt $\geq 80\%$ bis $\leq 100$ %, ganz besonders bevorzugt $\geq 95\%$ bis $\leq 100$ %.

Dabei bedeutet eine Belegungsdichte von 100% insbesondere, dass die umgebende organische Matrix keinen direkten Kontakt zu den Halbleiter-Nanoteilchen hat.

Die molaren Anteile der p- und/oder n-leitenden Materialien in dem photoaktiven Tensidmaterial können dabei zwischen 0 % und 100 % variieren, bevorzugt jedoch zwischen 20% und 80%. Besonders bevorzugt ist das Verhältnis der molaren Anteile der p- und n-leitenden Materialien in dem photoaktiven Tensidmaterial umgekehrt proportional zu dem Verhältnis der Absorption (Optische Dichte) der p- und n-leitenden Komponenten der gesamten Solarzelle gemäß der Formel

$$\frac{n_p}{n_n} = A \cdot \frac{a_n}{a_p} \cdot \frac{\sigma_n}{\sigma_p}$$

wobei $n_p$ für molare Menge des p-leitenden Materials, $n_n$ für die molare Menge des n-leitenden Materials in dem photoaktiven Tensidmaterial, entsprechend $a_{n\ bzw.\ p}$ für die Absorption des n- bzw. p-leitenden Materials n der Solarzelle und $\sigma_{n\ bzw.\ p}$ für die Leitfähigkeit des n- und p-leitenden photoaktiven Tensidmaterial steht und wobei der Faktor A von $\geq 0{,}05$ und $\leq 20$, bevorzugt $\geq 0{,}5$ bis $\leq 1{,}5$ und besonders bevorzugt $\geq 0{,}8$ bis $\leq 1{,}2$ beträgt.

Dadurch kann bei vielen Anwendungen innerhalb der vorliegenden Erfindung die Effizienz des Transports der Ladungsträger in die erforderliche Richtung (Elektronen in Richtung n-Halbleiter, Löcher in Richtung p-Halbleiter) verbessert werden.

Für den Fall, dass z.B. das p-leitende Polymer eine höhere Absorption hat, ist es gemäß einer bevorzugen Ausführungsform der vorliegenden Erfindung gewünscht, dass verstärkt Elektronen zum n-leitenden Halbleiter-Nanopartikel übergehen und somit ist ein höherer Anteil an n-leitenden, photoaktivem Tensidmaterial vorzuziehen. Für den Fall, dass das p-leitende Polymer eine niedrigere Absorption als die n-leitenden Halbleiter-Nanopartikel besitzen, verhält es sich es gemäß einer bevorzugen Ausführungsform der vorliegenden Erfindung umgekehrt. Analog ist es gemäß einer bevorzugen Ausführungsform der vorliegenden Erfindung vorzugehen, falls das Polymer n-leitend und die Halbleiter-Nanopartikel p-leitend ist.

Gemäß einer bevorzugten Ausführungsform der vorliegenden Erfindung sind die Halbleiter-Nanopartikel in einer photoaktiven organischen Matrix eingebettet.

Dabei wird unter einer photoaktiven organischen "Matrix" im Sinne der vorliegenden Erfindung insbesondere verstanden, dass ein halbleitendes, organisches Material mit geeigneter Bandlücke und geeigneten HOMO-LUMO-Lagen die Nanopartikel bis auf Kontaktbereiche zwischen den Nanopartikeln und Kontaktbereiche zu ladungsabführenden Elektroden komplett einhüllt. Eine geeignete Bandlücke besitzt das Material, wenn durch den Kontakt mit den verwendeten Halbleiter-Nanoteilchen die dem Fachmann bekannte Typ II Heterojunction entsteht. In einer bevorzugten Ausführungsform ist dabei die Energiedifferenz zwischen dem LUMO des Akzeptors und dem HOMO des Donors und somit die theoretisch erreichbare Klemmenspannung der Solarzelle möglichst groß.

Für den Fall, dass der Akzeptor eine höhere Absorption als der Donor aufweist, ist in einer bevorzugten Ausführungsform die Energiedifferenz zwischen dem HOMO des Akzeptors und dem HOMO des Donors abzüglich der Exzitonenbindungsenergie zwischen $\geq$0,01 eV und $\leq$0,6 eV, besonders bevorzugt ist diese Energiedifferenz zwischen $\geq$0,05 eV und $\leq$0,3 eV.

Für den Fall, dass der Donor eine höhere Absorption als der Akzeptor aufweist, ist in einer bevorzugten Ausführungsform die Energiedifferenz zwischen dem LUMO des Akzeptors und dem LUMO des Donors abzüglich der Exzitonenbindungsenergie zwischen $\geq$ 0,01 eV und $\leq$ 0,6 eV, besonders bevorzugt ist diese Energiedifferenz zwischen $\geq$ 0,05 eV und $\leq$ 0,3 eV.

Die organische Matrix umfasst gemäß einer bevorzugten Ausführungsform der Erfindung mindestens eine photoaktive, halbleitende organische Substanz. Dabei können bevorzugt die (1) Halbleiter-Nanopartikel eher n-leitend und die organische Matrix eher p-leitend sein oder (2) umgekehrt.

Um einen Elektronenfluss in Richtung Kathode zu gewährleisten muss das LUMO des Tensidmaterials energetisch höher liegen als das des eher n-leitenden aber niedriger als das LUMO abzüglich der Exzitonenbindungsenergie des eher p-leitenden Materials, so dass Elektronen in das n-leitende Material abgeführt werden können. Ebenso muss das HOMO des Tensidmaterials energetisch höher liegen als das des eher n-halbleitenden aber niedriger als das des eher p-leitenden Materials, so dass Löcher in die organische Matrix und somit in Richtung Anode fließen können. Die Lage des LUMO des Tensidmaterials liegt im ersten Fall (1) bevorzugt nahe an der des Halbleiter-Nanopartikels, damit das Tensidmaterial für den Transport der Elektronen von einem Partikel zum nächsten bis zur Kathode eine möglichst geringe energetische Barriere darstellt. Der energetische Abstand der LUMO's von Tensid (wobei das LUMO des Tensides leicht höher liegt) und n-leitendem Nanopartikel beträgt bevorzugt $\leq$ 0,6 eV, besonders bevorzugt $\leq$ 0,3 eV und ganz besonders bevorzugt $\leq$ 0,1 eV. In jedem Fall aber muss die Differenz zwischen den LUMO's von p-leitendem

Polymer und n-leitendem Nanopartikel bzw. Tensid so groß sein, dass die Energiedifferenz ausreicht, um eine Trennung des im absorbierenden Material generierten gebundenen Elektronen-Loch Paares (Exziton) herbeizuführen. Entsprechend ist die Lage des HOMO im zweiten Fall (2) bevorzugt nahe an der des Halbleiter-Nanopartikels, damit das Tensidmaterial für den Transport der Löcher von einem Partikel zum nächsten bis zur Anode eine möglichst geringe energetische Barriere darstellt. Der energetische Abstand der HOMO's beträgt bevorzugt $\leq$ 0,6 eV, besonders bevorzugt $\leq$ 0,3 eV und ganz besonders bevorzugt $\leq$ 0,1 eV.

Gemäß der Erfindung bevorzugt wird die Konstellation der Energieniveaus des Tensidmaterials und der Nanopartikel zueinander derart gewählt, dass gilt:

$$\frac{\Delta E_{Tensid}}{\Delta E_{Nano}} \geq \frac{HOMO(Nano) + X - LUMO(Nano)}{HOMO(Nano) + Y - LUMO(Nano)} \text{ für p-leitende Tensidmaterialien}$$

und/oder

$$\frac{\Delta E_{Tensid}}{\Delta E_{Nano}} \geq \frac{HOMO(Nano) - X - LUMO(Nano)}{HOMO(Nano) - Y - LUMO(Nano)} \text{ für n-leitende Tensidmaterialien}$$

wobei Y in einem Bereich von $0 \leq Y \leq 1{,}5$ eV, besonders bevorzugt $0{,}1 \leq Y \leq 0{,}8$ eV, und X in einem Bereich von $0 \leq X \leq 1$ eV, besonders bevorzugt $0{,}1 \leq X \leq 0{,}5$ eV gewählt ist.

In einer weiteren bevorzugten Ausführungsform absorbiert das Tensidmaterial zumindest in einem Teil des Wellenlängenbereichs, in der das Sonnenlicht eine hohe Intensität (400 nm bis 1000 nm) hat, mit einer Absorption von $\varepsilon \geq 10^{-4} \cdot nm^{-1}$, bevorzugt $\varepsilon \geq 10^{-3} \cdot nm^{-1}$, besonders bevorzugt $\varepsilon \geq 10^{-2} \cdot nm^{-1}$ und trägt dadurch aktiv zur Generierung von Exzitonen in der photoaktiven Schicht der Solarzelle bei. Dabei steht die Absorption mit der einheitenlosen Optischen Dichte OD in der Beziehung $OD = \varepsilon \cdot d$. Das Symbol d entspricht hier der Schichtdicke des Tensidmaterials um die Halbleiter-Nanopartikel.

Gemäß einer bevorzugten Ausführungsform der vorliegenden Erfmdung umfasst die Matrix ein organisches Polymer. Dies hat sich bei vielen Anwendungen der vorliegenden Erfindung insoweit als vorteilhaft herausgestellt, als dass so auf einfache Weise die gewünschte Solarzelle aufgebaut werden kann, z.B. durch Druck- oder Gießverfahren.

<u>Allgemeine Gruppendefinition:</u> Innerhalb der Beschreibung und den Ansprüchen werden allgemeine Gruppen, wie z.B: Alkyl, Alkoxy, Aryl etc. beansprucht und beschrieben. Wenn nicht anders beschrieben, werden bevorzugt die folgenden Gruppen innerhalb der allgemein beschriebenen Gruppen im Rahmen der vorliegenden Erfindung verwendet:

alkyl: lineare und verzweigte C1-C8-Alkyle,

langkettige Alkyle: lineare und verzweigte C5-C20 Alkyle

alkenyl: C2-C8-alkenyl,

cycloalkyl: C3-C8-cycloalkyl,

alkoxy: C1-C6-alkoxy,

langkettig Alkoxy: lineare und verzweigte C5-C20 Alkoxy

alkylene: ausgewählt aus der Gruppe enthaltend:

methylene; 1,1-ethylene; 1,2-ethylene; 1,1-propylidene; 1,2-propylene; 1,3- propylene; 2,2-propylidene; butan-2-ol-1,4-diyl; propan-2-ol-1,3-diyl; 1, 4-butylene; cyclohexane-1,1-diyl; cyclohexan-1,2-diyl; cyclohexan-1,3- diyl; cyclohexan-1,4-diyl; cyclopentane-1,1-diyl; cyclopentan-1,2-diyl; und cyclopentan-1,3-diyl,

aryl: ausgewählt aus Aromaten mit einem Molekulargewicht unter 300Da.

arylene: ausgewählt aus der Gruppe enthaltend: 1,2-phenylene; 1,3- phenylene; 1,4-phenylene; 1,2-naphtalenylene; 1,3-naphtalenylene; 1,4- naphtalenylene; 2,3-naphtalenylene; 1-hydroxy-2,3-phenylene; 1-hydroxy-2,4- phenylene; 1-hydroxy-2,5- phenylene; und 1-hydroxy-2,6-phenylene,

heteroaryl: ausgewählt aus der Gruppe enthaltend: pyridinyl; pyrimidinyl; pyrazinyl; triazolyl; pyridazinyl; 1,3,5-triazinyl; quinolinyl; isoquinolinyl; quinoxalinyl; imidazolyl; pyrazolyl; benzimidazolyl; thiazolyl; oxazolidinyl; pyrrolyl; thiophenyl; carbazolyl; indolyl; und isoindolyl, wobei das Heteroaryl mit der Verbindung über jedes Atom im Ring des ausgewählten Heteroaryls verbunden sein kann.

heteroarylene: ausgewählt aus der Gruppe enthaltend: pyridindiyl; quinolindiyl; pyrazodiyl; pyrazoldiyl; triazolediyl; pyrazindiyl, thiophendiyl; und imidazolediyl, wobei das heteroarylene als Brücke in der Verbindung über ein beliebiges Atom im Ring des ausgewählten Heteroaryls fungiert, speziell bevorzugt sind: pyridin-2, 3-diyl; pyridin-2,4-diyl; pyridin-2,5-diyl; pyridin-2,6-diyl; pyridin-3,4- diyl; pyridin-3,5-diyl; quinolin-2,3-diyl; quinolin-2,4-diyl; quinolin-2, 8-diyl; isoquinolin-1,3-diyl; isoquinolin-1,4-diyl; pyrazol-1,3-diyl; pyrazol-3,5- diyl; triazole-3,5-diyl; triazole-1,3-diyl; pyrazin-2,5-diyl; und imidazole-2,4-diyl, thiophen-2,5-diyl, thiophen-3,5-diyl; ein -C1-C6-heterocycloalkyl, ausgewählt aus der Gruppe enthaltend: piperidinyl; piperidine; 1,4-piperazine, tetrahydrothiophene; tetrahydrofuran; 1,4,7-triazacyclononane; 1,4,8,11- tetraazacyclotetradecane; 1,4,7,10,13-pentaazacyclopentadecane; 1,4-diaza- 7-thia-cyclononane; 1,4- diaza-7-oxa-cyclononane; 1,4,7,10-tetraazacyclododecane; 1,4-dioxane; 1,4, 7-trithia-cyclononane; pyrrolidine; und tetrahydropyran, wobei das Heteroaryl mit dem C1-C6-Alky! über jedes Atom im Ring des ausgewählten Heteroaryls verbunden sein kann.

heterocycloalkylene: ausgewählt aus der Gruppe enthaltend: piperidin-1,2- ylene; piperidin-2,6-ylene; piperidin-4,4-ylidene; 1,4-piperazin-1,4-ylene; 1,4-piperazin-2,3-ylene; 1,4-piperazin-2,5-ylene; 1,4-piperazin-2,6-ylene; 1,4-piperazin- 1,2-ylene; 1,4-piperazin-1,3-ylene; 1,4-piperazin-1,4-ylene; tetrahydrothiophen-2,5-ylene; tetrahydrothiophen-3,4-ylene; tetrahydrothiophen-2,3-ylene; tetrahydrofuran-2,5-ylene; tetrahydrofuran- 3,4-ylene; tetrahydrofuran-2,3-ylene; pyrrolidin-2,5-ylene; pyrrolidin-3,4-ylene; pyrrolidin-2,3-ylene; pyrrolidin-1,2-ylene; pyrrolidin-1,3-ylene; pyrrolidin-2,2-ylidene; 1,4,7-triazacyclonon-1,4-ylene; 1,4,7- triazacyclonon-2,3-ylene; 1,4,7-triazacyclonon-2,9-ylene; 1,4,7-triazacyclonon-3,8-ylene; 1,4,7-triazacyclonon-2,2- ylidene; 1,4,8,11-tetraazacyclotetradec-1,4-ylene; 1,4,8,11- tetraazacyclotetradec-1,8-ylene; 1,4,8,11-tetraazacyclotetradec-2,3-ylene; 1,4,8,11-tetraazacyclotetradec-2,5-ylene; 1,4,8,11- tetraazacyclotetradec-1,2-ylene; 1,4,8,11-tetraazacyclotetradec-2,2-ylidene; 1,4,7,10-tetraazacyclododec-1,4-ylene; 1,4,7,10-tetraazacyclododec-1,7-ylene; 1,4,7,10-tetraazacyclododec-1,2- ylene; 1,4,7,10-tetraazacyclododec-2,3- ylene; 1,4,7,10-tetraazacyclododec-2,2-ylidene; 1,4,7,10,13 pentaazacyclopentadec-1,4-ylene; 1,4,7,10,13- pentaazacyclopentadec-1,7-ylene; 1,4,7,10,13-pentaazacyclopentadec-2,3- ylene; 1,4,7,10,13-pentaazacyclopentadec-1,2-ylene; 1,4,7,10, 13-pentaazacyclopentadec-2,2-ylidene; 1,4-diaza-7-thia-cyclonon- 1,4-ylene; 1,4-diaza-7-thia-cyclonon-1,2-ylene; 1,4-diaza-7thia-cyclonon- 2,3-ylene; 1,4-diaza-7-thia-cyclonon-6,8-ylene; 1,4-diaza-7-thia-cyclonon- 2,2-ylidene; 1,4-diaza-7-oxacyclonon-1,4-ylene; 1,4-diaza-7-oxa-cyclonon- 1,2-ylene; 1,4diaza-7-oxa-cyclonon-2,3-ylene; 1,4-diaza-7-oxa-cyclonon-6, 8-ylene; 1,4-diaza-7-oxa-cyclonon-2,2-ylidene; 1,4-dioxan-2,3-ylene; 1,4- dioxan-2,6-ylene; 1,4-dioxan-2,2-ylidene; tetrahydropyran-2,3-ylene; tetrahydropyran-2,6-ylene; tetrahydropyran-2,5-ylene; tetrahydropyran-2,2- ylidene; 1,4,7-trithia-cyclonon-2,3-ylene; 1,4,7-trithia-cyclonon-2,9- ylene; und 1,4,7-trithia-cyclonon-2,2-ylidene,

heterocycloalkyl: ausgewählt aus der Gruppe enthaltend: pyrrolinyl; pyrrolidinyl; morpholinyl; piperidinyl; piperazinyl; hexamethylene imine; 1,4-piperazinyl; tetrahydrothiophenyl; tetrahydrofuranyl; 1,4,7- triazacyclononanyl; 1,4,8,11-tetraazacyclotetradecanyl; 1,4,7,10,13-pentaazacyclopentadecanyl; 1,4-diaza-7-thiacyclononanyl; 1,4-diaza-7-oxa- cyclononanyl; 1,4,7,10-tetraazacyclododecanyl; 1,4-dioxanyl; 1,4,7- trithiacyclononanyl; tetrahydropyranyl; und oxazolidinyl, wobei das Heterocycloalkyl mit der Verbindung über jedes Atom im Ring des ausgewählten Heterocycloalkyls verbunden sein kann.

halogen: ausgewählt aus der Gruppe enthaltend: F; Cl; Br und I,

halogenalkyl: ausgewählt aus der Gruppe enthaltend mono, di, tri-, poly und perhalogenated lineare und verzweigte C1-C8-alkyl

pseudohalogen: ausgewählt aus der Gruppe enthaltend -CN, -SCN, -OCN, N3, -CNO, -SeCN

Soweit nicht anders erwähnt, sind die folgenden Gruppen mehr bevorzugte Gruppen innerhalb der allgemeinen Gruppendefinition:

alkyl: lineare und verzweigte C1-C6-alkyl,

langkettige Alkyle: lineare und verzweigte C5-C10 alkyl, vorzugsweise C6-C8 alkyle

alkenyl: C3-C6-alkenyl,

cycloalkyl: C6-C8-cycloalkyl,

alkoxy: C1-C4-alkoxy,

langkettig Alkoxy: lineare und verzweigte C5-C10 alkoxy, vorzugsweise lineare C6-C8 alkoxy

alkylene: ausgewählt aus der Gruppe enthaltend: methylene; 1,2-ethylene; 1,3-propylene; butan-2-ol-1,4-diyl; 1,4-butylene; cyclohexane-1,1-diyl; cyclohexan-1,2-diyl; cyclohexan-1,4-diyl; cyclopentane-1,1-diyl; und cyclopentan-1,2-diyl,

aryl: ausgewählt aus der Gruppe enthaltend: phenyl; biphenyl; naphthalenyl; anthracenyl; und phenanthrenyl,

arylene: ausgewählt aus der Gruppe enthaltend: 1,2-phenylene; 1,3- phenylene; 1,4-phenylene; 1,2-naphtalenylene; 1,4-naphtalenylene; 2,3- naphtalenylene und 1-hydroxy-2,6-phenylene,

heteroarylene: Thiophen, Pyrrol, Pyridin, Pyridazin, Pyrimidin, Indol, Thienothiophen

halogen: ausgewählt aus der Gruppe enthaltend: F und Cl,

Gemäß einer bevorzugten Ausführungsform der vorliegenden Erfindung umfasst die Matrix ein organisches Polymer der Struktur

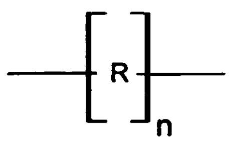

wobei jedes R unabhängig voneinander aus der Gruppe enthaltend unsubstituierte, alkylsubstituierte und/oder alkoxysubstituierte Arylene und alkylsubstituierte und/oder alkoxysubstituierte Heteroarylene ausgewählt ist und $n \geq 2$, bevorzugt $n \geq 4$ bis $\leq 400$ beträgt.

Gemäß einer bevorzugten Ausführungsform der vorliegenden Erfindung umfasst die Matrix ein organisches Polymer der Struktur

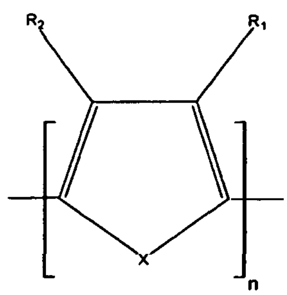

wobei jedes X für jede Einheit unabhängig voneinander aus der Gruppe enthaltend N, O, P, S ausgewählt ist, $R_1$ und $R_2$ für jede Einheit unabhängig aus der Gruppe enthaltend Wasserstoff, Alkyl, Alkoxy ausgewählt sind und n von $\geq 4$ bis $\leq 500$,bevorzugt von $\geq 15$ bis $\leq 400$ besonders bevorzugt von $\geq 20$ bis $\leq 300$ beträgt.

Gemäß einer bevorzugten Ausführungsform der vorliegenden Erfindung umfasst die Matrix ein organisches Polymer der Struktur

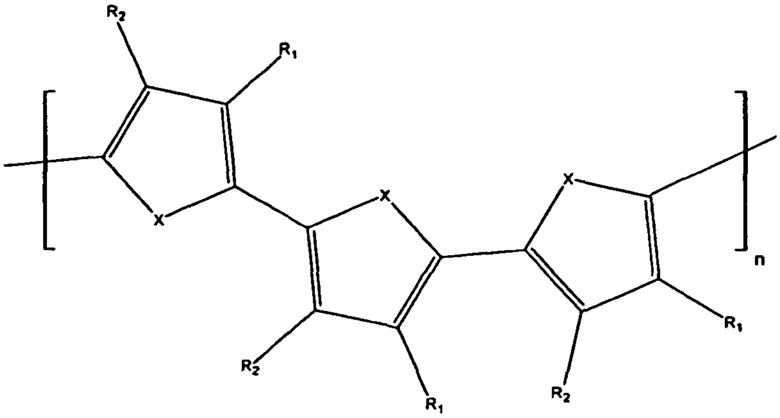

wobei jedes X für jede Einheit unabhängig voneinander aus der Gruppe enthaltend N, O, P, S ausgewählt ist, $R_1$ und $R_2$ für jede Einheit unabhängig aus der Gruppe enthaltend Wasserstoff, Alkyl, Alkoxy ausgewählt sind und n von ≥ 4 bis ≤ 300, bevorzugt von ≥ 15 bis ≤ 250, besonders bevorzugt von ≥ 20 bis ≤ 150 beträgt

Gemäß einer bevorzugten Ausführungsform der vorliegenden Erfindung umfasst die Matrix ein organisches Polymer der Struktur

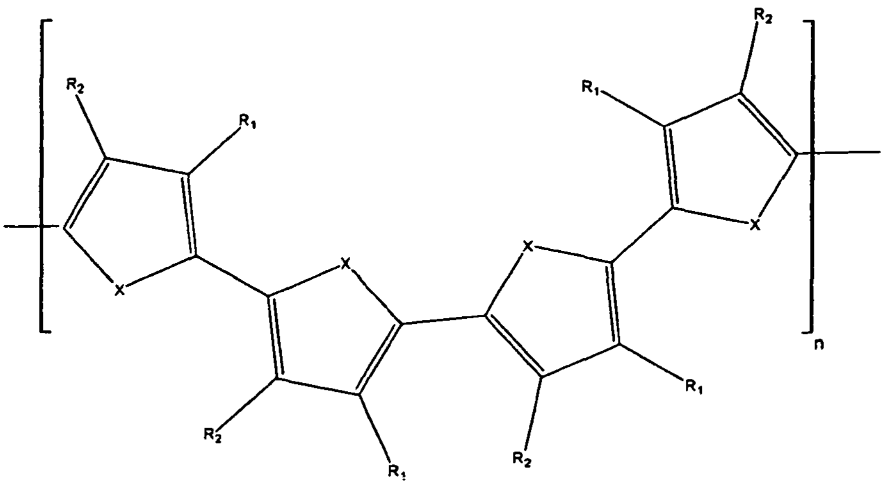

wobei jedes X für jede Einheit unabhängig voneinander aus der Gruppe enthaltend N, O, P, S ausgewählt ist, $R_1$ und $R_2$ für jede Einheit unabhängig aus der Gruppe enthaltend Wasserstoff, Alkyl, Alkoxy ausgewählt sind und n von ≥ 4 bis ≤ 300, bevorzugt von ≥ 15 bis ≤ 250, besonders bevorzugt von ≥ 20 bis ≤ 150 beträgt.

Gemäß einer bevorzugten Ausführungsform der vorliegenden Erfindung gilt für das Volumenverhältnis VA von Halbleiter-Nanopartikel zuzüglich des umgebenden Tensidmaterials zu der photoaktiven Schicht:

$$VA = \frac{V_{Nano} + V_{Tensid}}{V_{Aktive \cdot Schicht}}$$

und wird so gewählt, dass VA von ≥ 0,1, bevorzugt ≥ 0,2 bis ≤ 0,74, sowie noch bevorzugt ≥ 0,35 bis ≤ 0,6 beträgt.

Der Volumenanteil VA der Halbleiter-Nanopartikel zuzüglich des umgebenden Tensidmaterials in der photoaktiven Schicht ist gemäß einer bevorzugten Ausführungsform hoch genug sein um genügend Perkolationspfade zu der entsprechenden Elektrode zur Ableitung der Elektronen durch das n-leitende bzw. der Löcher durch das p-leitende Material sicher zu stellen. Gemäß einer bevorzugten Ausführungsform der vorliegenden Erfindung ist der Volumenanteil der Halbleiter-Nanopartikel zuzüglich des umgebenden Tensidmaterials mindestens so hoch, dass die mittlere Entfernung von dem Entstehungsort eines Elektron-Loch-Paares zur nächsten Grenzfläche Polymer-Nanoteilchen nicht größer als die Diffusionslänge des Elektron-Loch-Paares ist, die ca. 5 - 30 nm beträgt.

Der optimale Volumenanteil hängt bei vielen Anwendungen insbesondere auch von der Morphologie der Halbleiter-Nanopartikel ab. Er ist umso niedriger, desto größer die Exzitonen-Diffusionslänge ist und desto mehr die Partikel von der Kugelform abweichen. Für kugelförmige Teilchen ist er gemäß einer bevorzugten Ausführungsform zwischen ≥ 0,2und < kugelförmige Teilchen ist er gemäß einer bevorzugten Ausführungsform zwischen ≥ 0,2 und ≤ 0,7 und besonders bevorzugt zwischen ≥ 0,3 und ≤ 0,65. Für stäbchenförmige Teilchen mit einem Achsenverhältnis von mindestens 3:1 beträgt er bevorzugt zwischen ≥ 0,15 und ≤ 0,65 und besonders bevorzugt zwischen ≥ 0,25 und ≤ 0,6, wobei bei größerem Achsenverhältnis (> 5:1) die untere Grenze des Volumenanteils günstig ist (≥ 0,25 bis ≤ 0,45). Für Multipodenförmige Teilchen sollte er bevorzugt zwischen ≥ 0,1 und ≤ 0,6 und besonders bevorzugt zwischen ≥ 0,2 und ≤ 0,5 liegen, wobei das Achsenverhältnis der Ausläufer der Multipoden mindestens 3:1 betragen sollte. Bei einem Achsenverhältnis von mindestens 5:1 ist die untere Grenze des Volumenanteils günstig (≥ 0, bis ≤ 0,4).

Mit diesen Grenzen wird bei einer Vielzahl von Anwendungen innerhalb der vorliegenden Erfindung auch die obige Forderung bzgl. der Perkolationspfade erfüllt. Ein zu hoher Volumenanteil an Halbleiter-Nanopartikel kann den Anteil des sich durch Absorption in einem bestimmten Wellenlängenbereich auszeichnenden Polymers reduzieren. Deshalb sollte in einer bevorzugten Ausführungsform der vorliegenden Erfindung der Volumenanteil an Nanoteilchen höchstens ≤ 60 % betragen. Die Gesamtabsorption der Solarzelle wird bei einer Vielzahl von Anwendungen innerhalb der vorliegenden Erfindung insgesamt aller Wahrscheinlichkeit nach und ohne darauf festgelegt zu sein sowohl von der Zusammensetzung der drei photoaktiven Komponenten (organische Matrix, Tensidmaterial, Halbleiter-Nanoteilchen), deren Volumenanteile zueinander als auch von deren Schichtdicke bestimmt.

Gemäß einer bevorzugten Ausführungsform der vorliegenden Erfindung umfasst das Tensidmaterial auch ein p-leitendes Material, welches eine Loch-Mobilität von ≥ 0,001 $cm^2/Vs$ bis ≤ 10 $cm^2/Vs$, bevorzugt von ≥ 0,01 $cm^2/Vs$ bis ≤ 5 $cm^2/Vs$, besonders bevorzugt von ≥ 0,05 $cm^2/Vs$ bis ≤ 2 $cm^2/Vs$ aufweist.

Bevorzugt umfasst das mindestens eine Tensidmaterial mindestens auch ein p-leitendes Material der Struktur

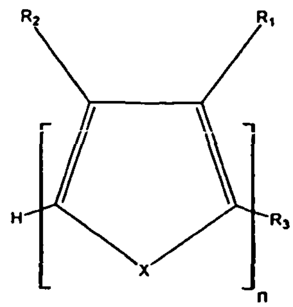

wobei jedes X für jede Einheit unabhängig voneinander aus der Gruppe enthaltend N, O, P, S ausgewählt ist, $R_1$ und $R_2$ für jede Einheit unabhängig aus der Gruppe enthaltend Wasserstoff, Alkyl, Alkoxy ausgewählt sind, $R_3$ ausgewählt ist aus der Gruppe enthaltend Carboxylat, Amine, Thiole, Phosphat, Sulfat und n von ≥ 3 bis ≤ 15 beträgt.

Gemäß einer bevorzugten Ausführungsform der vorliegenden Erfindung umfasst das Tensidmaterial ein n-leitendes Material und beträgt bevorzugt die Mobilität innerhalb des Tensidmaterials von ≥ 0,00001 $cm^2/Vs$ bis ≤ 10 $cm^2/Vs$, bevorzugt von ≥ 0,001 $cm^2/Vs$ bis ≤ 5 $cm^2/Vs$, besonders bevorzugt von ≥ 0,01 $cm^2/Vs$ bis ≤ 5 $cm^2/Vs$.

Das mindestens eine Tensidmaterial gemäß Anspruch 1 umfasst mindestens ein n-leitendes Material der Struktur

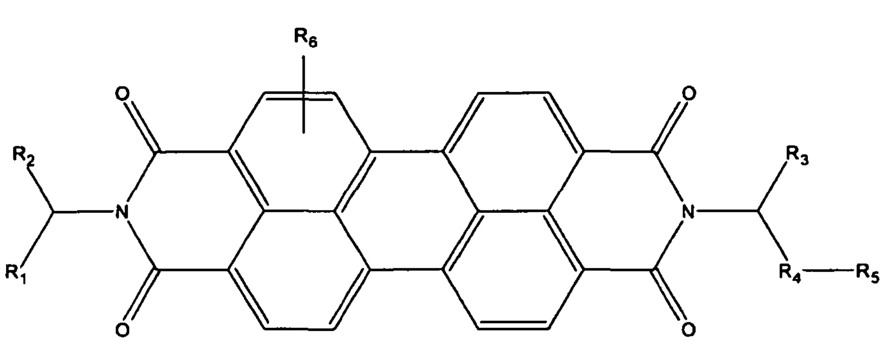

wobei $R_1$, $R_2$, $R_3$ und $R_6$ unabhängig aus der Gruppe enthaltend Wasserstoff, Alkyl, Alkoxy ausgewählt sind, $R_4$ für eine Einfachbindung und/oder eine Alkyleneinheit steht und $R_5$ ausgewählt ist aus der Gruppe enthaltend Carboxylat, Amine, Thiole, Phosphat, Sulfat, oder mindestens ein n-leitendes Material der Struktur

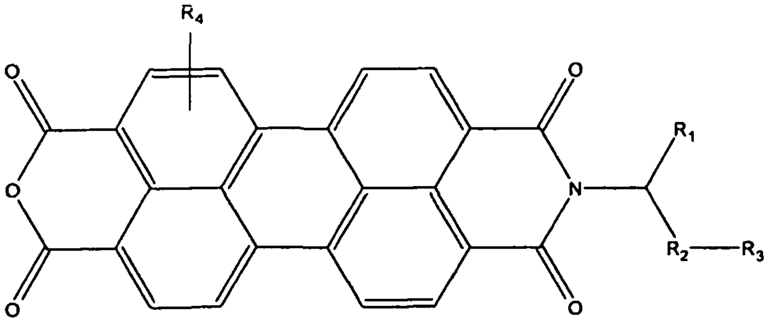

wobei $R_1$ und $R_4$ unabhängig aus der Gruppe enthaltend Wasserstoff, Alkyl, Alkoxy ausgewählt sind, $R_2$ für eine Einfachbindung und/oder eine Alkyleneinheit steht und $R_3$ ausgewählt ist aus der Gruppe enthaltend Carboxylat, Amine, Thiole, Phosphat, Sulfat.

Gemäß einer bevorzugten Ausführungsform der vorliegenden Erfindung umfasst das Tensidmaterial mindestens ein Material mit einer Löslichkeit von ≥ 10 g/l bis ≤ 400 g/l in mindestens einem Lösemittel mit einem $E_T(30)$-Wert von ≥ 30 bis ≤ 42.

Unter "$E_T(30)$-Wert" wird die Polarität eines Lösemittels verstanden, wobei sich im Rahmen der vorliegenden Erfindung auf die Werte bezogen wird, welche in Reichart; Dimroth, Fortschr. Chem. Forsch. 1969, 11, 1-73, Reichart, Angew. Chem. 1979, 91, 119 -131 sowie zitiert in March, Advanced Organic Chemistry, 4. Auflage, J. Wiley & Sons, 1992, Tabelle 10.13, S.361 veröffentlicht worden sind.

Die vorliegende Erfindung bezieht sich außerdem auf die Verwendung einer Solarzelle gemäß der vorliegenden Erfindung für portable Elektronikanwendungen (z.B. Mobiltelefon, MP3-Player, Notebooks, Medizintechnik etc.), für die Nutzung im Automobilbereich zur Stromerzeugung für diverse elektrische Verbraucher, für die Nutzung von halbtransparenten Solarzellen bei der Gebäude-, Gewächshaus- oder Automobilverglasung, bei Uhren, Designobjekten, für die Nutzung einer solchen Solarzelle in Form einer voll flexiblen und frei gestaltbaren Folie, für die stationäre Energiegewinnung in Form von Dach- und Wandaufbauten oder Folien, für die Einarbeitung in Kleidungsstücke.

Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Aunahmebedingungen, so dass die in dem Anwendungsgebiet bekannten Auswahlkriterien uneingeschränkt Anwendung finden können.

Weitere Einzelheiten, Merkmale und Vorteile des Gegenstandes der Erfindung ergeben sich aus den Unteransprüchen sowie aus der nachfolgenden Beschreibung der zugehörigen Zeichnungen, in denen - beispielhaft - mehrere Ausführungsbeispiele einer erfindungsgemäßen Solarzelle dargestellt sind. In den Zeichnungen zeigt:

- Fig. 1 eine sehr schematische Schnittansicht durch eine Solarzelle gemäß einer ersten Ausführungsform der Erfindung;
- Fig. 2 eine sehr schematische Schnittansicht durch mehrere von Tensidmaterial umgebenden Halbleiter-Nanopartikel der Solarzelle aus Fig. 1; sowie
- Fig. 3 eine sehr schematische Schnittansicht durch eine Solarzelle gemäß einer zweiten Ausführungsform der Erfindung.
- Fig. 4 ein Diagramm mit einer typischen Strom-Spannungs-Kennlinie für eine Solarzelle gemäß Beispiel 1.
- Fig. 5 ein Diagramm mit einer typischen Strom-Spannungs-Kennlinie für eine Solarzelle gemäß Beispiel 2.
- Fig. 6 eine transmissionselektronenmikroskopische Aufnahme eines Querschnitts einer Solarzelle gemäß der zweiten Ausführungsform der Erfindung.

Fig. 1 zeigt eine sehr schematische Schnittansicht durch eine Solarzelle 1 gemäß einer ersten Ausführungsform der Erfindung. Die Solarzelle beinhaltet eine erste Elektrode 50, welche in der vorliegenden Ausführungsform aus einem transparenten Material wie etwa ITO besteht. Grundsätzlich kommen hier aber alle auf dem Gebiet bekannten Materialien, insbesondere sog. TCO (Transparent Conductive Oxides = transparente leitende Oxide) aber auch in dünnen Schichten aufgetragene funktionalisierte SWCNT's (Single Wall Carbon Nanotubes) oder funktionalisierte MWCNT's (Multi Wall Carbon Nanotubes) in Frage.

Auf der Solarzelle aufgebracht ist eine Schicht eines ersten p-leitenden Polymers 40. Die Schicht ist etwa 40 nm dick und besteht in dieser Ausführungsform im Wesentlichen aus PEDOT:PSS. Auch hier kommen aber alle auf dem Gebiet bekannten Materialien in Frage, die Elektronen blockende Eigenschaften aufweisen und für Licht in den relevanten Wellenlängenbereichen transparent sind, so das erwähnte PEDOT:PSS oder HIL.

Die photoaktive Schicht 10 besteht in der vorliegenden Ausführungsform aus einer Schicht der erfindungsgemäßen mit photoaktivem Tensidmaterial beschichteten Halbleiter-Nanopartikel 20, welche in das Matrixmaterial eingebettet sind.

Zusätzlich ist eine Schicht 30 aufgebracht (deren Dicke 10nm oder weniger beträgt), die aus reinem Matrixmaterial besteht. Dadurch wird ein möglicher Kurzschluss zwischen den Halbleiter-Nanopartikeln 20 und des p-leitenden Polymers 40 vermieden. Das Matrixmaterial in dieser Ausführungsform ist P3HT (Poly-3-Hexylthiophen). Ebenfalls kommen hier die oben erwähnten Polymere infrage. Für die Schichtdicke gilt hier, dass das Produkt aus Gesamtabsorption der Solarzelle und der Elektronen- und der Lochleitfähigkeit, bedingt durch die Ausbildung genügend effektiver Perkolationspfade zur Ableitung der Elektronen durch das n-leitende bzw. der Löcher durch das p-leitende Material, maximal wird.

Anschließend folgt nun eine Schicht der erfindungsgemäßen von photoaktivem Tensidmaterial umgebenden Halbleiter-Nanopartikel 20, welche in das Matrixmaterial eingebettet sind. Es sei darauf hingewiesen, dass insbesondere dieser Abschnitt der Figur sehr schematisch gezeichnet ist. Die tatsächlichen Größenverhältnisse, Volumenanteile sowie Morphologien werden je nach konkreter Anwendung höchst unterschiedlich sein.

Abschließend ist auf der photoaktiven Schicht 10 eine zweite Elektrode 60 aufgebracht, welche in der vorliegenden Ausführungsform im Wesentlichen aus Aluminium besteht.

<u>Fig. 2</u> zeigt eine sehr schematische Schnittansicht durch mehrere von Tensidmaterial umgebenden Halbleiter-Nanopartikel 20 der Solarzelle aus Fig. 1. In dieser Zeichnung ist (sehr schematisch) zu sehen, dass die Halbleiter-Nanopartikel aus Halbleiter-Material 21 bestehen, welches von photoaktivem Tensidmaterial 22 umgeben ist. Wenn nun durch Einstrahlung von Licht durch Absorption von Photonen Exzitonen erzeugt werden und die gebundenen Elektronen-Loch Paare an die Grenzfläche Nanopartikel/Polymer diffundieren, kann nun (wie in der Fig. durch die Pfeile angedeutet) eine effizientere Ladungstrennung über das photoaktive Tensidmaterial 22 erfolgen, was die Effizienz der Solarzelle erhöht.

In einer konkreten Ausführungsform bestehen die Halbleiter-Nanopartikeln im Wesentlichen aus CdSe und sind von einer Mischung eines n-leitenden Tensidmaterials, welches aus einem an einem Ende phosphatierten Polythiophen und eines p-leitenden Perylenmaterials umgeben.

Es sei deutlich darauf hingewiesen, dass auch Fig.2 eine sehr schematische Zeichnung ist. In realen Systemen werden die Größenverhältnisse sich deutlich von denen der Fig. 2 unterscheiden, da die Halbleiterpartikel 21 bevorzugt von einer Monolayerschicht des photoaktiven Materials 22 umgeben sind.

Weiterhin sei darauf hingewiesen, dass zwar die Halbleiterpartikel 21 in Fig. 1 und Fig. 2 mit rundem Durchmesser gezeigt wurden, jedoch alle denkbaren Morphologien für die Halbleiterpartikel in Frage kommen und je nach konkreter Anwendung der Erfindung auch bevorzugt sein können.

So bestehen die Halbleiterpartikel gemäß einer bevorzugten Ausführungsform aus Stäbchen (d.h. sind im Wesentlichen 1-dimensional), sind gemäß einer weiteren Ausführungsform blattähnlich aufgebaut (d.h. sind im Wesentlichen 2-dimensional) oder besitzen eine dreidimensionale Form, welche kreisförmig, angenähert ellipsoid und/oder eine Tetrapod-Form sein kann.

Es sei darauf hingewiesen, dass je nach Anwendung auch Halbleiterpartikel unterschiedlicher Morphologien in der photoaktiven Schicht vorhanden sein können.

<u>Fig. 3</u> zeigt eine sehr schematische Schnittansicht durch eine Solarzelle 1' gemäß einer zweiten Ausführungsform der Erfindung. Diese Ausführung unterscheidet sich von der aus Fig. 1, dadurch, dass eine weitere Schicht 70 (ein sog. "Hole-Blocking-Layer" z.B. Phenyl C61 Butyric Acid Methyl Ester) aufgebracht ist, die den ungewollten Übergang von Löchern in die Aluminium-Elektrode verhindert.

<u>Fig. 4</u> zeigt ein Diagramm mit einer typischen Strom-Spannungs-Kennlinie für eine Solarzelle gemäß Beispiel 1 unter Beleuchtungsbedingungen, die näherungsweise dem Strahlungsspektrum bei 1,5 AM entsprechen. Die Kennlinie wurde für eine Solarzelle bestehend aus CdSe Nanopartikeln und P3HT aufgenommen.

<u>Fig. 5</u> zeigt ein Diagramm mit einer typischen Strom-Spannungs-Kennlinie für eine Solarzelle gemäß Beispiel 2 unter Beleuchtungsbedingungen, die näherungsweise dem Strahlungsspektrum bei 1,5 AM entsprechen. Die Kennlinie wurde für eine Solarzelle bestehend aus CdSe Nanopartikeln, photoaktivem Tensidmaterial und P3HT aufgenommen.

<u>Fig. 6</u> zeigt eine transmissionselektronenmikroskopische Aufnahme eines Querschnitts einer Solarzelle gemäß der zweiten Ausführungsform der Erfindung bestehend aus CdSe Nanopartikeln, photoaktivem Tensidmaterial und P3HT.

**<u>Beispiele:</u>**

**<u>Beispiel 1:</u> Aufarbeitung CdSe Nanopartikel in Pyridin und Herstellung einer CdSe/P3HT Solarzelle**

Zur Entfernung des Tensids, welches bei der Synthese der CdSe Nanopartikel eingesetzt wird, werden 35 mg der CdSe Nanopartikel erst in 2 mL Toluol und anschließend in 20 mL Pyridin redispergiert (Toluol zu Pyridin Verhältnis: 1/10). Durch Kochen (Temperatur ca. 117°C für 2 h) unter Rückfluss und inerter Atmosphäre erfolgt ein Austausch der

Liganden, so dass Pyridin die vorhandenen Tenside an der Oberfläche der Nanopartikel größtenteils ersetzt. Die darauffolgende Fällung der mit Pyridin beschichteten Nanopartikel erfolgt mit 200 mL n-Hexan (Pyridin zu n-Hexan Verhältnis: 1/10). Dieser Schritt ist gleichzeitig auch ein Test für einen erfolgreichen Ligandenaustausch. Die aussedimentierten CdSe Nanopartikel werden durch Zentrifugation (für 1 h bei einer Beschleunigung von ca. 2200 g) vom überschüssigen Lösungsmittel- und Tensidgemisch abgetrennt. Zur weiteren Aufreinigung können die Nanopartikel dann erneut in 3 mL Pyridin redispergiert und in 30 mL n-Hexan gefällt werden. Überschüssige Lösungsmittel- und Tensidanteile werden durch Zentrifugieren abgetrennt (für 10 min bei einer Beschleunigung von ca. 2200 g). Nach dem letzten Aufreinigungsschritt erfolgt die Redispergierung der mit Pyridin beschichteten CdSe Nanopartikel in einem Gemisch bestehend aus 7 Vol.-% Pyridin in Chlorbenzol (eingesetztes Volumen ca. 1 mL). Dieser Mischung werden dann 180 µL einer P3HT/Chorbenzollösung (50 mg/mL) zugesetzt. Diese Lösung kann nun für die Herstellung von Solarzellen genutzt werden, wobei in der Lösung einen Massenverhältnis von CdSe Nanopartikeln zu P3HT von 90/10 vorliegt.

Die Solarzelle wird dann wie folgt präpariert. Das gleichmäßige Aufbringen der CdSe/P3HT Dispersion auf einer mit ITO und PEDOT:PSS beschichteten Glasplatte erfolgt mittels Spin Coater bei einer Umdrehungszahl von 1500 1/min für 30 s. Der so entstandene Film (siehe Fig. 6) wird anschließend bei 150°C für 15 min getempert. Danach wird die Rückelektrode durch Aufdampfen einer Aluminiumschicht aufgebracht. Die Solarzelle wurde dann unter Bedingungen vermessen die näherungsweise dem Strahlungsspektrum bei 1,5 AM entsprechen.

**<u>Beispiel 2:</u> Aufarbeitung CdSe Nanopartikel in Pyridin und photoaktivem Tensidmaterial und Herstellung einer CdSe/photoaktives Tensidmaterial/P3HT Solarzelle**

Zur Entfernung des Tensids, welches bei der Synthese der CdSe Nanopartikel eingesetzt wird, werden 35 mg der CdSe Nanopartikel erst in 2 mL Toluol und anschließend in 20 mL Pyridin redispergiert (Toluol zu Pyridin Verhältnis: 1/10). Durch Kochen (Temperatur ca. 117°C für 2 h) unter Rückfluss und inerter Atmosphäre erfolgt ein Austausch der Liganden, so dass Pyridin die vorhandenen Tenside an der Oberfläche der Nanopartikel größtenteils ersetzt. Die darauffolgende Fällung der mit Pyridin beschichteten Nanopartikel erfolgt mit 200 mL n-Hexan (Pyridin zu n-Hexan Verhältnis: 1/10). Dieser Schritt ist gleichzeitig auch ein Test für einen erfolgreichen Ligandenaustausch. Die aussedimentierten CdSe Nanopartikel werden durch Zentrifugation (für 1 h bei einer Beschleunigung von ca. 2200 g) vom überschüssigen Lösungsmittel- und Tensidgemisch abgetrennt. Zur weiteren Aufreinigung können die Nanopartikel dann erneut in 3 mL Pyridin redispergiert und in 30 mL n-Hexan gefällt werden.

Nach dem letzten Aufreinigungsschritt erfolgt die Redispergierung der mit Pyridin beschichteten CdSe Nanopartikel in einem Gemisch bestehend aus 9 Vol.-% Pyridin in Chlorbenzol (eingesetztes Volumen ca. 3 mL). Durch Eindampfen mit Stickstoff wird das Gemisch aus CdSe Nanopartikeln, Pyridin und Chlorbenzol auf eine Partikelkonzentration von ca. 25mg/mL eingestellt. Anschließend erfolgt die Zugabe von 76 µL einer P3HT/Chlorbenzollösung (50 mg/mL) und 77 µL einer Lösung aus photoaktivem Tensidmaterial und Chlorbenzol (50mg/mL). Diese Lösung kann nun für die Herstellung von Solarzellen genutzt werden, wobei in der Lösung einen Massenverhältnis von CdSe Nanopartikeln zu photoaktivem Tensidmaterial und P3HT von 82/9/9 vorliegt.

Die Solarzelle wird dann wie folgt präpariert. Das gleichmäßige Aufbringen der CdSe/P3HT Dispersion auf einer mit ITO und PEDOT:PSS beschichteten Glasplatte erfolgt mittels Spin Coater bei einer Umdrehungszahl von 1500 1/min für 30 s. Der so entstandene Film (siehe Fig. 6) wird anschließend bei 150°C für 15 min getempert. Danach wird die Rückelektrode durch Aufdampfen einer Aluminiumschicht aufgebracht. Die Solarzelle wurde dann unter Bedingungen vermessen die näherungsweise dem Strahlungsspektrum bei 1,5 AM entsprechen.

**Patentansprüche**

1. Solarzelle, enthaltend mindestens einen von mindestens einem photoaktiven Tensidmaterial umgebenen Halbleiter-Nanopartikel in zumindest einem Teil der photoaktiven Schicht, wobei

    a) die Halbleiter-Nanopartikel Verbindungshalbleiter aus den Gruppen II-VI oder III-V und Mischungen daraus sind **dadurch gekennzeichnet, dass**
    b) das mindestens eine photoaktive Tensidmaterial

        i. ein n-leitendes Material gemäß der Formel:

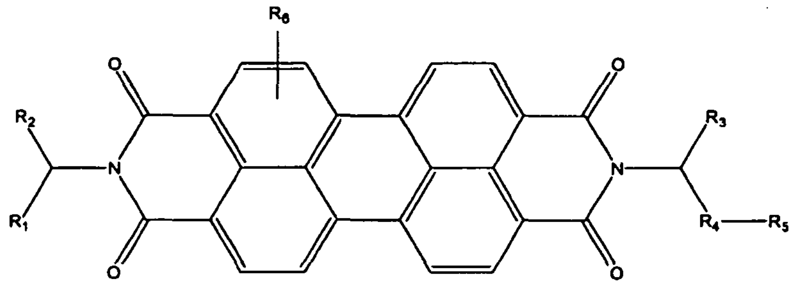

(I)

in der $R_1$, $R_2$, $R_3$ und $R_6$ unabhängig voneinander aus der Gruppe bestehend aus Wasserstoff, Alkyl, Alkoxy ausgewählt sind, $R_4$ eine Einfachbindung und/oder eine Alkyleneinheit ist und $R_5$ ausgewählt ist aus der Gruppe bestehend aus Carboxylat, Amine, Thiole, Phosphat und Sulfat, oder
ii. ein n-leitendes Material gemäß der Formel:

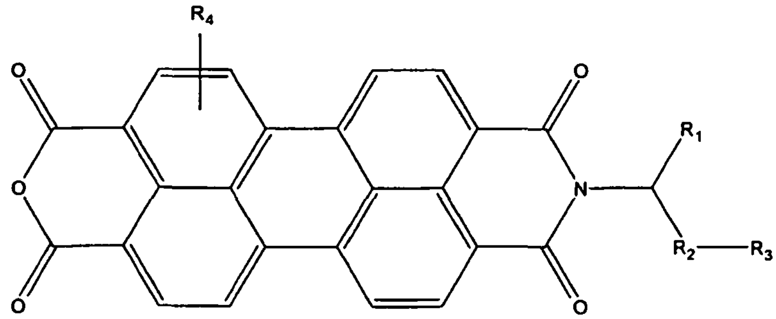

(II)

in der $R_1$ und $R_4$ unabhängig voneinander aus der Gruppe bestehend aus Wasserstoff, Alkyl, Alkoxy ausgewählt sind, $R_2$ eine Einfachbindung und/oder eine Alkyleneinheit ist und $R_3$ ausgewählt ist aus der Gruppe bestehend aus Carboxylat, Amine, Thiole, Phosphat und Sulfat

umfasst.

**2.** Solarzelle nach Anspruch 1, wobei die Belegungsdichte der Halbleiter Nanopartikeloberfläche im Durchschnitt von $\geq$ 50% bis $\leq$ 100 % beträgt.

**3.** Solarzelle nach einem der Ansprüche 1 oder 2, wobei die Halbleiter-Nanopartikel in einer photoaktiven Matrix eingebettet sind

**4.** Solarzelle nach einem der Ansprüche 1 bis 3, wobei das Volumenverhältnis VA von Halbleiter-Nanopartikel und dem umgebenden Tensidmaterial zu der photoaktiven Schicht

$$VA = \frac{V_{Nano} + V_{Tensid}}{V_{Aktive \cdot Schicht}}$$

$\geq$ 0,1, bevorzugt $\geq$ 0,2 bis $\leq$ 0,74, sowie noch bevorzugt $\geq$ 0,35 bis $\leq$ 0,6 beträgt.

**5.** Solarzelle nach einem der Ansprüche 1 bis 4, wobei das Tensidmaterial auch ein p-leitendes Material umfasst und die Mobilität innerhalb des Tensidmaterials von $\geq$ 0,001 $cm^2/Vs$ bis $\leq$ 10 $cm^2/Vs$ beträgt

**6.** Solarzelle nach einem der Ansprüche 1 bis 5, wobei das Tensidmaterial ein n-leitendes Material umfasst und die Mobilität innerhalb des Tensidmaterials von $\geq$ 0,00001 $cm^2/Vs$ bis $\leq$ 10 $cm^2/Vs$ beträgt.

7. Solarzelle nach einem der Ansprüche 1 bis 6, wobei das Tensidmaterial mindestens ein Material mit einer Löslichkeit von $\geq$ 10 g/l bis $\leq$ 400 g/l in mindestens einem Lösemittel mit einem $E_T$-Wert von $\geq$ 30 bis $\leq$ 42 umfasst.

8. Solarzelle nach einem der Ansprüche 5 bis 7, wobei das Tensidmaterial mindestens ein erstes p-leitendes Material und mindestens ein zweites n-leitendes Material umfasst und das Mischungsverhältnis von p-leitendem zu n-leitendem Material von 0,2 : 1 bis 4:1 beträgt.

9. Solarzelle nach einem der Ansprüche 5 bis 8, wobei das Verhältnis der molaren Anteile der p-und n-leitenden Materialien in dem photoaktiven Tensidmaterial umgekehrt proportional zu dem Verhältnis der Absorption (Optische Dichte) der p- und n-leitenden Komponenten der gesamten Solarzelle gemäß

$$\frac{n_p}{n_n} = A \cdot \frac{a_n}{a_p} \cdot \frac{\sigma_n}{\sigma_p}$$

beträgt,
wobei $n_p$ für molare Menge des p-leitenden Materials, $n_n$ für die molare Menge des n-leitenden Materials in dem photoaktiven Tensidmaterial, entsprechend $a_{n\ bzw.\ p}$ für die Absorption des n-bzw. p-leitenden Materials n der Solarzelle und $\sigma_{n\ bzw.}$ p für die Leitfähigkeit des n- und p-leitenden photoaktiven Tensidmaterial steht und wobei der Faktor A von $\geq$ 0,05 und $\leq$ 20 beträgt.

10. Verwendung einer Solarzelle nach einem oder mehreren der Ansprüche 1 bis 9 für portable Elektronikanwendungen, für die Nutzung im Automobilbereich zur Stromerzeugung für diverse elektrische Verbraucher, für die Nutzung von halbtransparenten Solarzellen bei der Gebäude-, Gewächshaus- oder Automobilverglasung, bei Uhren, Designobjekten, für die Nutzung einer solchen Solarzelle in Form einer voll flexiblen und frei gestaltbaren Folie, für die stationäre Energiegewinnung in Form von Dach- und Wandaufbauten oder Folien, für die Einarbeitung in Kleidungsstücke.

## Claims

1. Solar cell comprising at least one semiconductor nanoparticle surrounded by at least one photoactive surfactant material in at least one part of the photoactive layer, wherein

   a) the semiconductor nanoparticles are compound semiconductors from groups II-VI or III-V and mixtures thereof, **characterized in that**
   b) the at least one photoactive surfactant material comprises

      i. an n-conductive material of the formula:

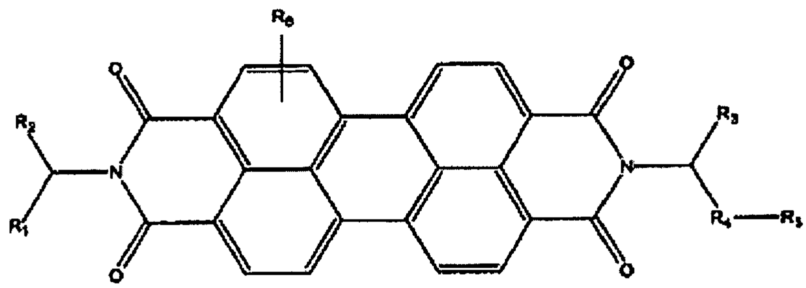

(I)

where $R_1$, $R_2$, $R_3$ and $R_6$ are selected independently from the group comprising hydrogen, alkyl, alkoxy, $R_4$ is a single bond and/or an alkylene unit, and $R_5$ is selected from the group comprising carboxylate, amines, thiols, phosphate and sulphate, or
ii.an n-conductive material of the formula:

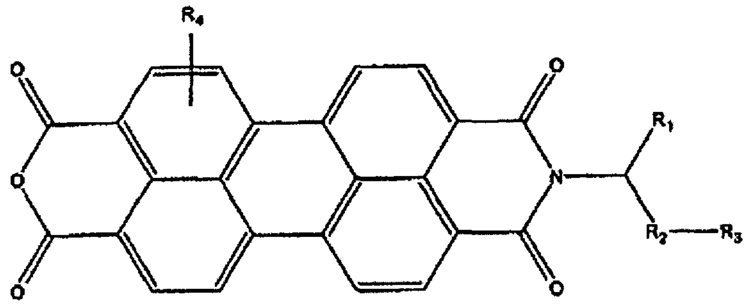

(II)

where $R_1$ and $R_4$ are selected independently from the group comprising hydrogen, alkyl, alkoxy, $R_2$ is a single bond and/or an alkylene unit, and $R_3$ is selected from the group comprising carboxylate, amines, thiols, phosphate and sulphate.

**2.** Solar cell according to Claim 1, wherein the coverage density of the semiconductor nanoparticle surface is, on average, ≥ 50% to ≤ 100%.

**3.** Solar cell according to either of Claims 1 and 2, wherein the semiconductor nanoparticles are embedded in a photoactive matrix.

**4.** Solar cell according to one of Claims 1 to 3, wherein the volume ratio VA of semiconductor nanoparticles and the surrounding surfactant material relative to the photoactive layer is

$$VA = \frac{V_{nano} + V_{surfactant}}{V_{active \cdot layer}}$$

≥ 0.1, preferably ≥ 0.2 to ≤ 0.74, and more preferably ≥ 0.35 to ≤ 0.6.

**5.** Solar cell according to one of Claims 1 to 4, wherein the surfactant material also comprises a p-conductive material and the mobility within the surfactant material is ≥ 0.001 $cm^2/Vs$ to ≤ 10 $cm^2/Vs$.

**6.** Solar cell according to one of Claims 1 to 5, wherein the surfactant material comprises an n-conductive material and the mobility within the surfactant material is ≥ 0.00001 $cm^2/Vs$ to ≤ 10 $cm^2/Vs$.

**7.** Solar cell according to one of Claims 1 to 6, wherein the surfactant material comprises at least one material having a solubility of ≥ 10 g/l to ≤ 400 g/l in at least one solvent having an $E_T$-value of ≥ 30 to ≤ 42.

**8.** Solar cell according to one of Claims 5 to 7, wherein the surfactant material comprises at least one first p-conductive material and at least one second n-conductive material, and the mixing ratio of p-conductive to n-conductive material is 0.2:1 to 4:1.

**9.** Solar cell according to one of Claims 5 to 8, wherein the ratio of the molar proportions of the p- and n-conductive materials in the photoactive surfactant material is inversely proportional to the ratio of the absorption (optical density) of the p- and n-conductive components of the overall solar cell according to

$$\frac{n_p}{n_n} = A \cdot \frac{a_n}{a_p} \cdot \frac{\sigma_n}{\sigma_p} ,$$

wherein $n_p$ is the molar amount of the p-conductive material, $n_n$ is the molar amount of the n-conductive material in the photoactive surfactant material, correspondingly $a_n$ or p is the absorption of the n- or p-conductive material n of

the solar cell and $\sigma_{n\ or\ p}$ is the conductivity of the n- and p-conductive photoactive surfactant material, and where the factor A is ≥ 0.05 to ≤ 20.

**10.** Use of a solar cell according to one or more of Claims 1 to 9 for portable electronic applications, for use in the automobile sector for generating electricity for various electrical loads, for the use of semi-transparent solar cells in glazing for buildings, greenhouses or automobiles, in watches, design objects, for the use of such a solar cell in the form of a fully flexible and freely shapeable film, for stationary energy generation in the form of roof and wall installations, or films for incorporation into items of clothing.

## Revendications

**1.** Cellule solaire, contenant dans au moins une partie de la couche photoactive au moins une nanoparticule de semi-conducteur entourée d'au moins un matériau tensioactif photoactif, dans laquelle

a) les nanoparticules de semi-conducteur sont des semi-conducteurs composés à base des groupes II-VI ou III-V et de mélanges de ceux-ci, **caractérisée en ce que**
b) ledit au moins un matériau tensioactif photoactif comprend

i. un matériau n-conducteur selon la formule :

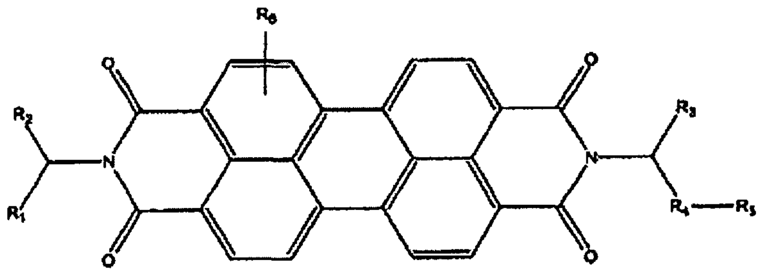

(I)

dans laquelle $R_1$, $R_2$, $R_3$ et $R_6$ sont choisis, indépendamment les uns des autres, dans l'ensemble constitué par un atome d'hydrogène, un groupe alkyle, alcoxy, $R_4$ est une simple liaison et/ou une unité alkylène et $R_5$ est choisi dans l'ensemble constitué par le groupe carboxylate, des amines, des thiols, le groupe phosphate et le groupe sulfate, ou
ii. un matériau n-conducteur selon la formule :

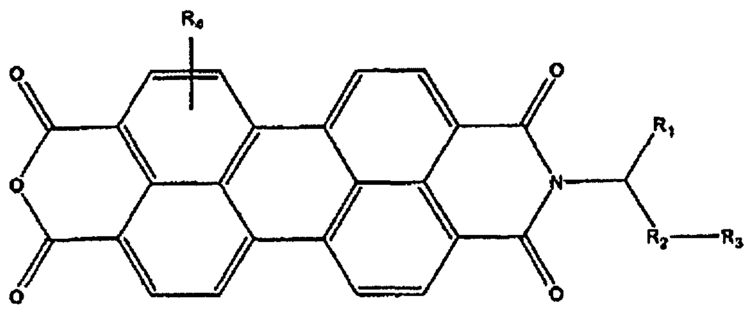

(II)

dans laquelle $R_1$ et $R_4$ sont choisis, indépendamment l'un de l'autre, dans l'ensemble constitué par un atome d'hydrogène, un groupe alkyle, alcoxy, $R_2$ est une simple liaison et/ou une unité alkylène et $R_3$ est choisi dans l'ensemble constitué par le groupe carboxylate, des amines, des thiols, le groupe phosphate et le groupe sulfate.

**2.** Cellule solaire selon la revendication 1, dans laquelle la densité d'occupation de la surface des nanoparticules de semi-conducteur vaut en moyenne de ≥ 50 % à ≤ 100 %.

3. Cellule solaire selon la revendication 1 ou 2, dans laquelle les nanoparticules de semi-conducteur sont incluses dans une matrice photoactive.

4. Cellule solaire selon l'une quelconque des revendications 1 à 3, dans laquelle le rapport volumique VA des nanoparticules de semi-conducteur et du matériau tensioactif qui les entoure à la couche photoactive

$$VA = \frac{V_{nano} + V_{tensioactif}}{V_{couche\ active}}$$

vaut ≥ 0,1, de préférence 0,2 à ≤ 0,74, ainsi qu'encore mieux ≥ 0,35 à ≤ 0,6.

5. Cellule solaire selon l'une quelconque des revendications 1 à 4, dans laquelle le matériau tensioactif comprend également un matériau p-conducteur et la mobilité à l'intérieur du matériau tensioactif vaut de ≥ 0,001 $cm^2/Vs$ à ≤ 10 $cm^2/Vs$.

6. Cellule solaire selon l'une quelconque des revendications 1 à 5, dans laquelle le matériau tensioactif comprend un matériau n-conducteur et la mobilité à l'intérieur du matériau tensioactif vaut de ≥ 0,00001 $cm^2/Vs$ à ≤ 10 $cm^2/Vs$.

7. Cellule solaire selon l'une quelconque des revendications 1 à 6, dans laquelle le matériau tensioactif comprend au moins un matériau ayant une solubilité de ≥ 10 g/l à ≤ 400 g/l dans au moins un solvant ayant une valeur $E\gamma$ de ≥ 30 à ≤ 42.

8. Cellule solaire selon l'une quelconque des revendications 5 à 7, dans laquelle le matériau tensioactif comprend au moins un premier matériau p-conducteur et au moins un deuxième matériau n-conducteur et le rapport de mélange du matériau p-conducteur au matériau n-conducteur vaut de 0,2 : 1 à 4 : 1.

9. Cellule solaire selon l'une quelconque des revendications 5 à 8, dans laquelle le rapport des quantités molaires des matériaux p-conducteur(s) et n-conducteur(s) dans le matériau tensioactif photoactif est inversement proportionnel au rapport de l'absorption (densité optique) des composants p- et n-conducteurs de la cellule solaire dans son ensemble, selon

$$\frac{n_p}{n_n} = A \cdot \frac{a_n}{a_p} \cdot \frac{\sigma_n}{\sigma_p}$$

$n_p$ représentant la quantité molaire du matériau p-conducteur, $n_n$ représentant la quantité molaire du matériau n-conducteur dans le matériau tensioactif photoactif, de façon correspondante $a_{n\ ou\ p}$ représentant l'absorption du matériau n n- ou p-conducteur de la cellule solaire et $\sigma_{n\ ou}$ p représentant la conductivité du matériau tensioactif photoactif n- ou p-conducteur et le facteur A valant de ≥ 0,05 à ≤ 20.

10. Utilisation d'une cellule solaire selon une ou plusieurs des revendications 1 à 9 pour des applications électroniques portables, pour l'emploi dans le secteur automobile pour la production de courant pour divers dispositifs consommant de l'électricité, pour l'emploi de cellules solaires semi-transparentes dans des vitrages de bâtiments, de serres ou d'automobiles, dans des montres, des objets de design, pour l'emploi d'une telle cellule solaire sous forme d'un film totalement flexible et librement configurable, pour la production d'énergie stationnaire sous forme d'éléments placés sur mur et toit ou de films, pour l'incorporation dans des pièces d'habillement.

Fig.1

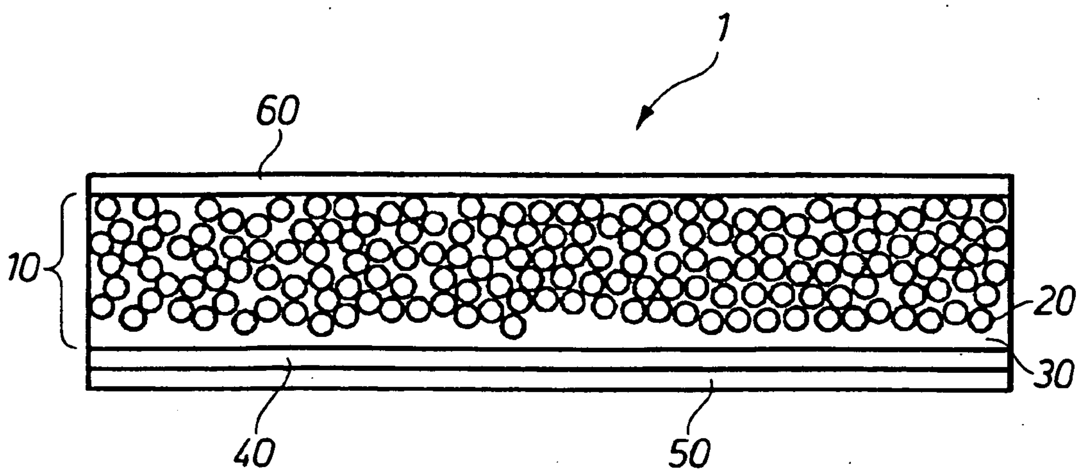


EPO - DG 1
08. 05. 2008

Fig.2

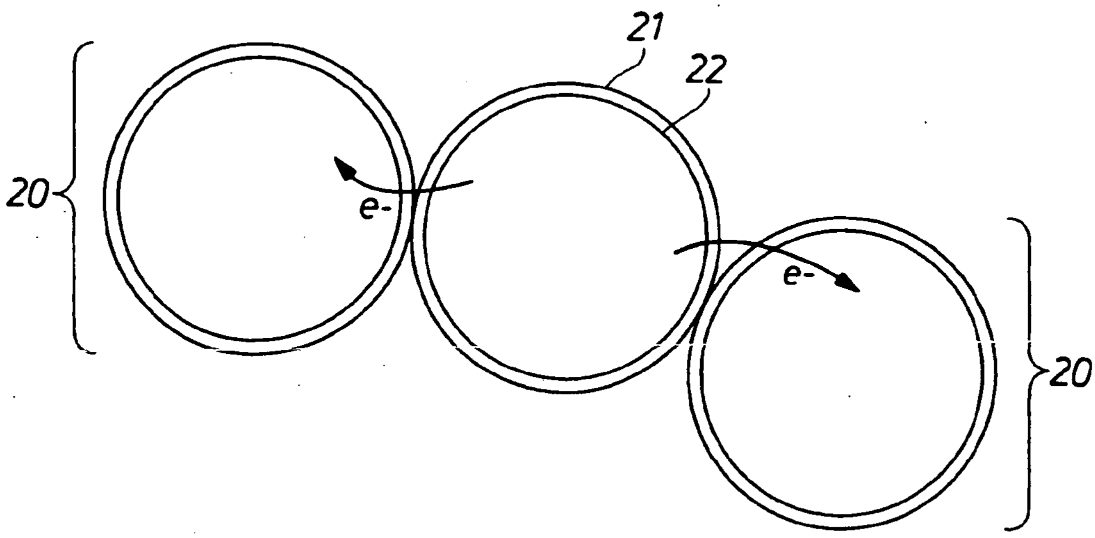

Fig. 3

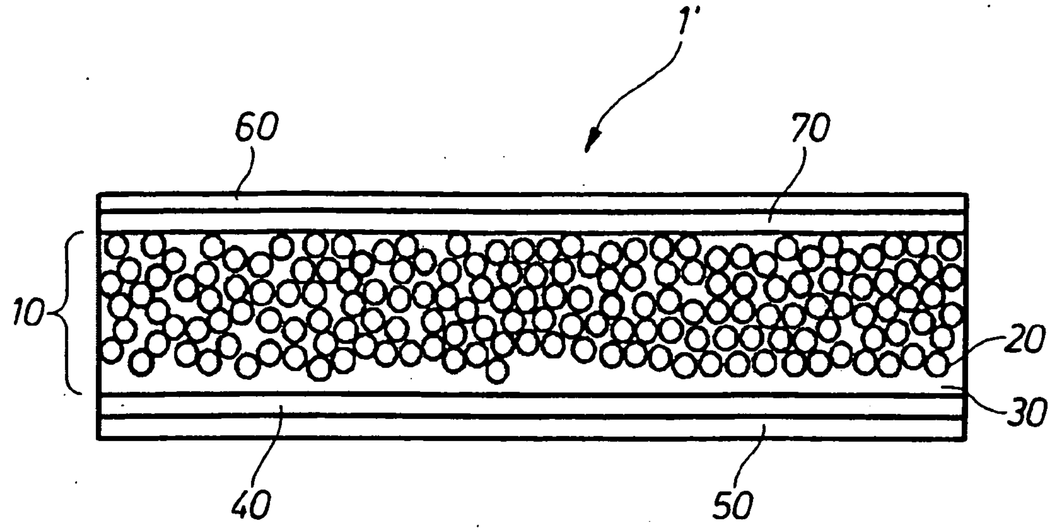
1'
60
70
10
20
30
40
50

Fig. 4

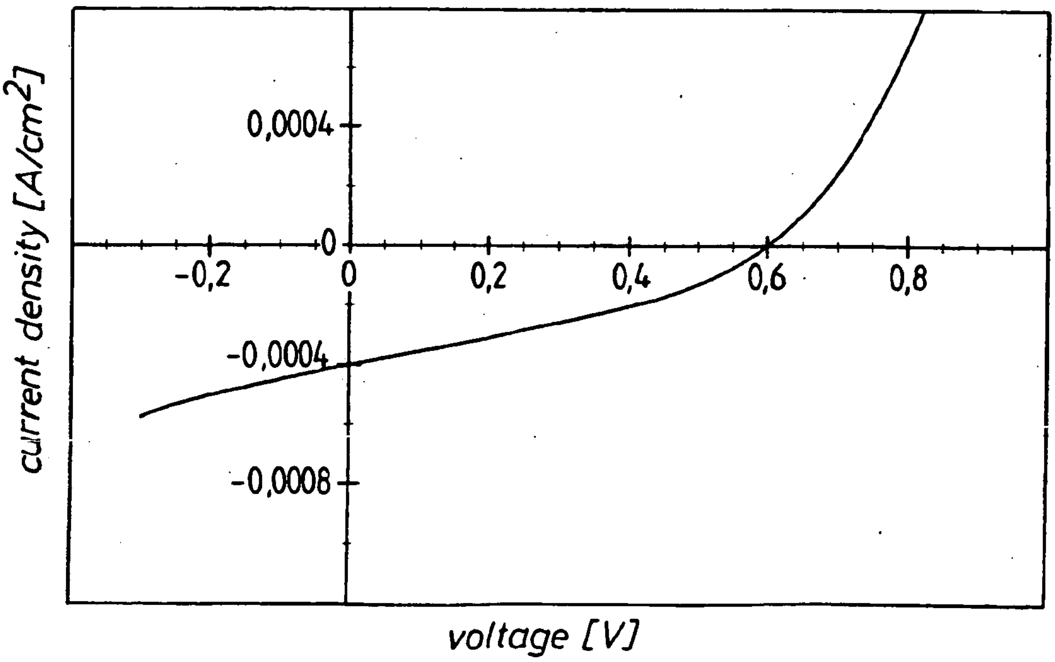
current density [A/cm²]
0,0004
0
-0,0004
-0,0008
-0,2
0
0,2
0,4
0,6
0,8
voltage [V]

Fig.5

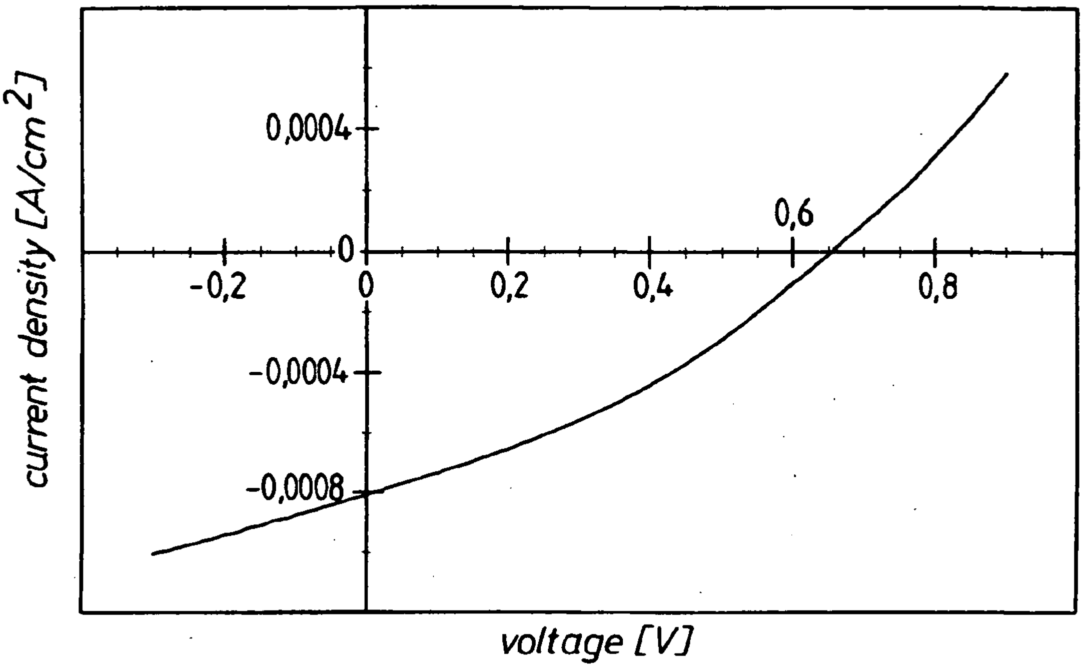
current density [A/cm$^2$]
0,0004
0
-0,0004
-0,0008
-0,2
0
0,2
0,4
0,6
0,8
voltage [V]

Fig.6

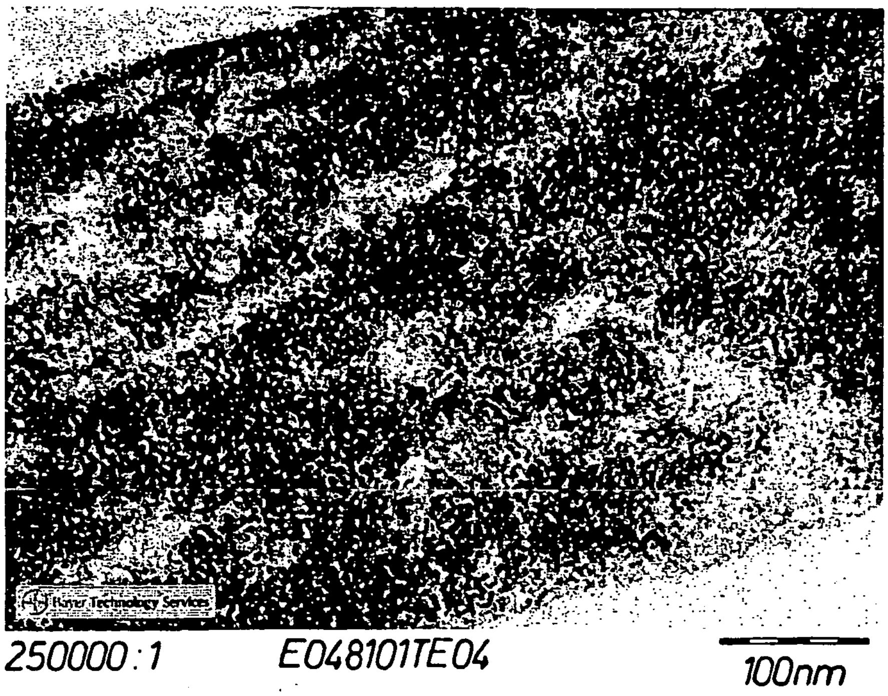
250000:1
E048101TE04
100nm

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 6878871 B
- EP 1473745 A
- WO 2004022714 A


### In der Beschreibung aufgeführte Nicht-Patentliteratur


- **L. SCHMIDT-MENDE et al.** Efficiency improvement in solid-state-dye-sensitized photovoltaics with an amphiphilc Ruthenium-dye. *Appl. Phys. Lett.,* 2004, vol. 86
- **REICHART; DIMROTH.** *Fortschr. Chem. Forsch.,* 1969, vol. 11, 1-73
- **REICHART.** *Angew. Chem.,* 1979, vol. 91, 119-131
- **MARCH.** Advanced Organic Chemistry. J. Wiley & Sons, 1992, 361